# EUROPÄISCHE PATENTANMELDUNG

(11) **EP 4 108 376 A1**
(43) Veröffentlichungstag der Anmeldung: **28.12.2022**
(21) Anmeldenummer: 21181813.3
(22) Anmeldetag: 25.06.2021
(51) Int. Cl.: B23K 26/34, C23C 14/04

(54) **LASER-INDUZIERTER VORWÄRTSTRANSFER (LIFT) MIT ANGEPASSTER DAMPFBLASE**

(71) Anmelder: Fraunhofer-Gesellschaft zur Förderung der angewandten Forschung e.V., 80686 München (DE)
(72) Erfinder: Lensing, Richard, 52064 Aachen (DE); Nottrodt, Nadine, 52064 Aachen (DE); Gillner, Arnold, 52064 Aachen (DE); Webner, Martin, 52064 Aachen (DE)
(74) Vertreter: Schrell, Andreas

(57) **Zusammenfassung**

Die vorliegende Erfindung betrifft ein Verfahren zur Laser-induzierten Übertragung verschiedener Materialien, bei dem eine gepulste, durchstimmbare Laserstrahlquelle verwendet wird und eine Absorption der Strahlungsenergie und Ausbildung einer Dampfblase direkt im Transfermaterial erfolgt. Auf diese Weise wird eine präzise regulierbare Lokalisierung, Dimensionierung und Geometrie der im Trägermaterial erzeugten Dampfblase ermöglicht, wodurch eine präzise verunreinigungsfreie Übertragung definierter Volumina an zu übertragenden Materialien von einem Transferträger auf einen Empfängerträger erzielt werden kann.

## Beschreibung

Die vorliegende Erfindung betrifft ein Verfahren zur Laser-induzierten Übertragung verschiedener Materialien, bei dem eine gepulste, durchstimmbare Laserstrahlquelle verwendet wird und eine Absorption der Strahlungsenergie und Ausbildung einer Dampfblase direkt im Transfermaterial erfolgt. Auf diese Weise wird eine präzise regulierbare Lokalisierung, Dimensionierung und Geometrie der im Trägermaterial erzeugten Dampfblase ermöglicht, wodurch eine präzise verunreinigungsfreie Übertragung definierter Volumina an zu übertragenden Materialien von einem Transferträger auf einen Empfängerträger erzielt werden kann.

Beim Laser-induzierten Drucken von flüssigen Materialien werden dünne Absorberschichten, sogenannte "dynamic release layer" (DRL) verwendet, um die Energie eines Laserstrahls zu absorbieren. Durch die Absorption der Strahlungsenergie in der Absorberschicht zwischen Trägersubstrat und Transfermaterial kommt es zur fokussierten lokalen Erhitzung und Ausbildung einer Dampfblase, die einen Jet aus Transfermaterial bewirkt, wodurch ein gezielter Transfer von Transfermaterial und/oder im Transfermaterial befindlichen Materialien über eine kurze Distanz zwischen Transferträger und Empfängerträger ermöglicht wird. Durch die Absorption der Strahlungsenergie wird die dünne Absorberschicht zwischen Trägersubstrat und Transfermaterial lokal zerstört oder beschädigt, sodass ein wiederholter Transfer von derselben Position nicht mehr möglich ist. Zudem können aus der Absorberschicht gelöste Partikel mitübertragen werden und in Form von Nanopartikeln oder größeren Fragmenten das gedruckte Material verunreinigen. Auch reduziert das Vorliegen einer Absorberschicht die Kontrolle über die erzeugte Dampfblasengeometrie, da ein Eindringen der Laserstrahlung in das Transfermaterial selbst verhindert wird und das verwendete Laserstrahlprofil sich nur unzureichend in der Geometrie der Dampfblase widerspiegelt.

Die Absorberschicht kann aus unterschiedlichen Materialien aufgebaut sein. Bei metallischen Absorberschichten wie Titan, Gold und Silber wurde gezeigt, dass heiße Partikel der Absorberschicht tief in das Transfermaterial vordringen können und dort kleinere zusätzliche Dampfblasen erzeugen, die den Transferprozess negativ beeinflussen. Auch kann es durch die heißen Partikel zu einer Schädigung von thermisch sensiblen Materialien kommen. Bei der Verwendung von Hydrogelen, wie Kollagen und Matrigel, als Absorberschicht werden für gewöhnlich UV-Laser mit Wellenlängen unterhalb von 200 nm eingesetzt. Durch die geringe Wellenlänge von UV-Licht kann es nachteiliger Weise während des Übertragungsprozesses von biologischen Materialien zur Schädigung der DNA kommen.

Im Bereich des zweidimensionalen (2D) und dreidimensionalen (3D) Drucks von flüssigen Materialien ist neben der Positionierungsgenauigkeit und Übertragungsrate insbesondere die Reinheit und Unversehrtheit des übertragenen Materials sowie eine präzise Kontrolle über die Volumina der übertragenen Flüssigkeitstropfen relevant. Bezüglich der Reinheitsanforderungen reichen die Anwendungen vom Drucken störstellenfreier optischer Elemente bis hin zum Transfer einzelner lebender Zellen im Bereich der Zellsortierung und des Gewebedrucks (Tissue Engineering). Bezüglich der Flüssigkeitsvolumina ist im sogenannten Laser-induzierten Vorwärtstransfer (LIFT) bisher die Übertragung von Flüssigkeitsmengen im Bereich von 10 fL bis 7000 pL gezeigt worden. Allerdings werden für verschiedene Tropfengrößen auch unterschiedliche Aufbauten und Schichtdicken des Transfermaterials benötigt. Eine präzise Einstellbarkeit der Tropfengröße über einen großen Bereich sowie die Erweiterung des bisher etablierten Prozesses zu kleineren und größeren Flüssigkeitsmengen ist für aktuelle Anwendungen der Technologie von zunehmender Bedeutung. Das Bestreben nach einer Verringerung der Tropfenvolumina ist dabei hauptsächlich durch die zunehmende Miniaturisierung von Bauteilen getrieben. Ein Beispiel dafür ist das Kleben von kleinsten Bauteilen mit hoher Präzision, bei dem einzelne Tropfen an Klebstoff kontaktfrei und automatisiert übertragen werden sollen. Neue Anforderungen an die maximal übertragbare Flüssigkeitsmenge werden beispielsweise im Laser Assisted Bioprinting (LAB) für den Aufbau von künstlichen Geweben gestellt. Um zunehmend größere Gewebe drucken zu können, muss die pro Zeiteinheit übertragene Anzahl an Zellen erhöht werden. Präzise einstellbare Tropfengrößen ermöglichen dabei die präzise Positionierung der benötigten Zelltypen und Zellzahlen, während Flüssigkeitsmengen über 7000 pL eine schnelle Flächenfüllung ermöglichen.

Im Stand der Technik sind unterschiedliche Ansätze zur Vermeidung einer Absorberschicht für den Laser-induzierten Transfer von Materialien bekannt. Ein Ansatz basiert auf dem Transfer aus einem Volumenbecken, auch film-free LIFT (FF-LIFT) genannt. Zhang et al. (Sacrificial-layer free transfer of mammalian cells using near infrared femtosecond laser pulses, PloS one, 2018, 13 (5)) beschreibt ein Verfahren, bei dem ein Laser-induzierter Zelltransfer dadurch erreicht wird, dass Laserstrahlung durch den Empfangsträger und das Biomaterial hindurch in der tieferliegenden Flüssigkeit fokussiert wird. Als Laserstrahlquelle wird ein Yb:KYW-Laser mit einer Wellenlänge von 1030 nm eingesetzt und eine maximale Pulsenergie von 10 µJ bei 450 fs Pulsdauer verwendet. In einem alternativen Ansatz beschreibt Patrascioiu et al. (Laser-generated liquid microjets. Correlation between bubble dynamics and liquid ejection, Microfluid Nanofluid, 2014, 16 (1-2), S. 55-63) ein Verfahren, bei dem die Laserstrahlung von unten durch das Becken des Transfermaterials knapp unter der Oberfläche fokussiert wird. Bei den vorgenannten Verfahren aus dem Stand der Technik werden hohe Fluenzen im Bereich von 10¹² W/cm² benötigt, um über nicht-lineare Absorption ausreichend Energie der Laserstrahlung in die Dampfblasenkinetik umzusetzen. Des Weiteren kommt es zu einer Belichtung des Transfermaterials außerhalb des Fokus, was bei fotosensiblen Transfermaterialien zu unerwünschten Alterungsprozessen führen kann. Im Falle von dem in Zhang et al. beschriebenen Verfahren können einzelne bereits übertragene Flüssigkeitstropfen das Strahlprofil beeinträchtigen, da sie aufgrund des gewählten Strahlengangs bei weiteren Übertragungsvorgängen im Strahlengang selbst liegen können und je nach Brechungsindex des Transfermaterials wie eine Linse wirken. Bei dem von Patrascioiu et al. beschriebenen Verfahren liegt durch die Tiefe des Beckens ein großes Totvolumen vor, das für den Transfer nicht genutzt werden kann.

Ein weiterer Ansatz zur Laser-induzierten Übertragung von Materialien ist das sogenannte "blister actuated" LIFT-Verfahren (BA-LIFT). Bei diesem Verfahren wird anstelle einer metallischen oder organischen Absorberschicht eine Polymerschicht mit einer Schichtdicke von 1 bis 10 µm verwendet. Dabei bildet sich die den Transfer auslösende Dampfblase nicht im Transfermaterial selbst, sondern zwischen Träger und Polymerschicht, wobei letztere irreversibel zu einem Blister verformt wird. Der Impuls der schlagartigen Ausdehnung wird an das Transfermaterial weitergegeben, wo sich ein Jet ausbildet. Dabei verläuft die Jet-Ausbildung analog zum gewöhnlichen LIFT-Verfahren unter Verwendung einer metallischen oder organischen Absorberschicht zur Absorption der Strahlungsenergie. Das BA-LIFT-Verfahren verringert oder umgeht die Gefahr von Verunreinigungen durch Partikel aus der Absorberschicht im gedruckten Material, da die Polymerschicht die Dampfblase vom Transfermaterial selbst trennt. Diese strikte Trennung hat allerdings auch den Nachteil, dass die Möglichkeit einer Kontrolle des Transferjets durch komplexe Dampfblasengeometrien stark eingeschränkt ist. Zudem ist ein mehrfaches Drucken an derselben Position durch die irreversible Verformung der Polymerschicht am Ort der Laserfokussierung nicht möglich.

Es besteht daher der Bedarf an einem verbesserten Verfahren zur Laser-induzierten Übertragung von Materialien, das eine verunreinigungsfreie und präzise Übertragung über einen großen Bereich einstellbarer Transfervolumina erlaubt.

Die vorliegende Erfindung löst das ihr zugrundeliegende Problem durch den Gegenstand der unabhängigen Ansprüche.

Dabei beschreibt die vorliegende Erfindung insbesondere ein Verfahren, bei dem auf eine spezifische Absorberschicht verzichtet werden kann und die von einem Transferträger auf einen Empfängerträger übertragene Materialmenge in einem LIFT-Prozess präzise und über einen großen Bereich eingestellt werden kann.

Die Erfindung betrifft insbesondere ein Verfahren zum Laser-induzierten Übertragung von Material umfassend die Schritte:
a) Bereitstellung eines Transferträgers umfassend ein für Laserstrahlung durchlässiges Trägersubstrat und ein das zu übertragende Material umfassendes Trägermaterial sowie einer gepulsten, durchstimmbaren Laserstrahlquelle,
b) Einstellung der Eigenschaften mindestens eines gepulsten fokussierten Laserstrahls,
c) Emittierung des mindestens einen gepulsten fokussierten Laserstrahls durch das Trägersubstrat in das Trägermaterial, wobei der mindestens eine gepulste fokussierte Laserstrahl die in Schritt b) eingestellten Eigenschaften aufweist und in dem Trägermaterial zur Ausbildung mindestens einer Dampfblase führt, und
d) Übertragung des zu übertragenden Materials vom Transferträger auf einen Empfängerträger.

Demnach handelt es sich bei dem erfindungsgemäße Verfahren um ein LIFT-Verfahren, das auf der Verwendung einer gepulsten, durchstimmbaren Laserstrahlquelle und der Einstellung der zur Übertragung von Material von einem Transferträger auf einen Empfangsträger verwendeten Eigenschaften eines gepulsten fokussierten Laserstrahls basiert, insbesondere dessen Laserwellenlänge, Rayleighlänge, Pulslänge, Pulsenergie, Fokuslage und/oder Laserstrahlprofil, sodass die gezielte Ausbildung einer Dampfblase, insbesondere einer Dampfblase mit vorbestimmter Lokalisierung, Dimensionierung und Geometrie, direkt im Trägermaterial erzielt werden kann ohne dafür eine separate Absorberschicht auf dem Transferträger zu benötigen. Auf diese Weise kann eine höhere Qualität der Druckerzeugnisse, insbesondere eine verunreinigungsfreie Übertragung von Material zwischen einem Transferträger und einem Empfängerträger, bewerkstellig werden. Zudem ist das erfindungsgemäße Verfahren ökonomischer, insbesondere weniger arbeitsaufwendig und günstiger, als LIFT-Verfahren bei denen ein mit einer Absorberschicht beschichteter Transferträger zur Absorption der Strahlungsenergie verwendet wird. Das Verfahren bietet ferner eine große Flexibilität in Bezug auf die Einstellbarkeit der gewünschten zu übertragenden Materialmenge. Zusätzlich erlaubt es das erfindungsgemäße Verfahren durch die Möglichkeit des Verzichts auf eine Absorberschicht, zu übertragendes Material mehrmals hintereinander von derselben Position auf dem Transferträger auf einen Empfangsträger zu übertragen. Durch diese Flexibilität wird dem Nutzer die Verwendung des erfindungsgemäßen Verfahrens in zahlreichen technischen Anwendungsgebieten ermöglicht. So kann das Verfahren zum Bioprinting eingesetzt werden, wie beispielsweise zur Zellsortierung, zum Organprinting und zum Tissue Engineering. Auch erlaubt das erfindungsgemäße Verfahren eine Miniaturisierung bei der gezielten Materialübertragung, wie sie beispielsweise für die präzise Positionierung von kleinsten Klebstofftropfen oder das Drucken von Mikrooptiken erforderlich ist.

In einer bevorzugten Ausführungsform der vorliegenden Erfindung weist der Transferträger keine Absorberschicht auf.

In einer weiteren bevorzugten Ausführungsform der vorliegenden Erfindung weist das Trägermaterial zusätzlich mindestens eine zur Absorption des gepulsten Laserstrahls geeignete Substanz auf. Besonders bevorzugt wird in dem erfindungsgemäßen Verfahren neben dem Trägermaterial selbst keine weitere zur Absorption des gepulsten Laserstrahls geeignete Substanz eingesetzt.

Gemäß einer bevorzugten Ausführungsform besteht das für Laserstrahlung durchlässige Trägersubstrat des Transferträgers aus Glas, bevorzugt aus Quarz.

Besonders bevorzugt weist das Trägermaterial des Transferträgers eine Schichtdicke von 1 bis 500 µm, bevorzugt 5 bis 400 µm, bevorzugt 10 bis 300 µm, bevorzugt 20 bis 200 µm, bevorzugt 30 bis 150 µm, bevorzugt 50 bis 100 µm, auf. Bevorzugt weist das Trägermaterial des Transferträgers eine Schichtdicke von höchstens 500 µm, bevorzugt höchstens 450 µm, bevorzugt höchstens 400 µm, bevorzugt höchstens 350 µm, bevorzugt höchstens 300 µm, bevorzugt höchstens 250 µm, bevorzugt höchstens 200 µm, bevorzugt höchstens 150 µm, bevorzugt höchstens 100 µm, bevorzugt höchstens 75 µm, bevorzugt höchstens 50 µm, auf.

Gemäß einer weiteren bevorzugten Ausführungsform der vorliegenden Erfindung handelt es sich bei dem Trägermaterial um eine Flüssigkeit oder ein wasserhaltiges Gel.

Besonders bevorzugt umfasst das wasserhaltige Gel mindestens eine Substanz ausgewählt aus der Gruppe bestehend aus Gelatine, Agarose, Chitosan, Matrigel, Kollagen und Methylzellulose.

In einer weiteren Ausführungsform der vorliegenden Erfindung handelt es sich bei dem Trägermaterial um einen Feststoff.

Gemäß einer besonders bevorzugten Ausführungsform der vorliegenden Erfindung sind die in Schritt b) eingestellten Eigenschaften des mindestens einen gepulsten fokussierten Laserstrahls ausgewählt aus der Gruppe bestehend aus Laserwellenlänge, Rayleighlänge, Pulslänge, Pulsenergie, Fokuslage und Laserstrahlprofil.

Bevorzugt sind die in Schritt b) eingestellten Eigenschaften des mindestens einen gepulsten fokussierten Laserstrahls mindestens zwei, bevorzugt mindestens drei, bevorzugt mindestens vier, Eigenschaften ausgewählt aus der Gruppe bestehend aus Laserwellenlänge, Rayleighlänge, Pulslänge, Pulsenergie, Fokuslage und Laserstrahlprofil.

In einer bevorzugten Ausführungsform umfassen die in Schritt b) eingestellten Eigenschaften des mindestens einen gepulsten fokussierten Laserstrahls die Wellenlänge.

Bevorzugt liegt die in Schritt b) eingestellte Wellenlänge im Bereich von 2,5 bis 3,5 µm, bevorzugt 2,75 bis 3,25 µm.

Besonders bevorzugt beträgt die in Schritt b) eingestellte Wellenlänge höchstens 5 µm, bevorzugt höchstens 4,5 µm, bevorzugt höchstens 4 µm, bevorzugt höchstens 3,5 µm, bevorzugt höchstens 3,25 µm, bevorzugt höchstens 3 µm. Gemäß einer bevorzugten Ausführungsform der vorliegenden Erfindung beträgt die in Schritt b) eingestellte Wellenlänge mindestens 0,5 µm, bevorzugt mindestens 1 µm, bevorzugt mindestens 1,25 µm, bevorzugt mindestens 1,5 µm, bevorzugt mindestens 1,75 µm, bevorzugt mindestens 2 µm, bevorzugt mindestens 2,25 µm, bevorzugt mindestens 2,5 µm.

Gemäß einer bevorzugten Ausführungsform der vorliegenden Erfindung umfassen die in Schritt b) eingestellten Eigenschaften des mindestens einen gepulsten fokussierten Laserstrahls die Rayleighlänge.

Besonders bevorzugt liegt die in Schritt b) eingestellte Rayleighlänge in einem Bereich von 10 µm bis 10 mm, bevorzugt 100 µm bis 10 mm, bevorzugt 150 µm bis 5 mm, bevorzugt 200 µm bis 1 mm, bevorzugt 250 µm bis 1 mm, bevorzugt 500 µm bis 1 mm.

In einer bevorzugten Ausführungsform der vorliegenden Erfindung liegt die in Schritt b) eingestellte Rayleighlänge bei mindestens 10 µm, bevorzugt mindestens 50 µm, bevorzugt mindestens 100 µm, bevorzugt mindestens 150 µm, bevorzugt mindestens 200 µm, bevorzugt mindestens 250 µm, bevorzugt mindestens 500 µm, bevorzugt mindestens 1 mm.

In einer weiteren bevorzugten Ausführungsform liegt die in Schritt b) eingestellte Rayleighlänge bei höchstens 10 mm, bevorzugt höchstens 8 mm, bevorzugt höchstens 6 mm, bevorzugt höchstens 4 mm, bevorzugt höchstens 2 mm, bevorzugt höchstens 1 mm, bevorzugt höchstens 750 µm, bevorzugt höchstens 500 µm, bevorzugt höchstens 250 µm, bevorzugt höchstens 200 µm, bevorzugt höchstens 150 µm, bevorzugt höchstens 100 µm, bevorzugt höchstens 50 µm, bevorzugt höchstens 25 µm.

In einer bevorzugten Ausführungsform umfassen die in Schritt b) eingestellten Eigenschaften des mindestens einen gepulsten fokussierten Laserstrahls die Pulslänge.

Bevorzugt liegt die in Schritt b) eingestellte Pulslänge im Bereich von 1 fs bis 500 ns, bevorzugt 10 fs bis 250 ns, bevorzugt 50 fs bis 100 ns, bevorzugt 100 fs bis 1 ns. Besonders bevorzugt liegt die in Schritt b) eingestellte Pulslänge im Bereich von 0.01 bis 10 ns, bevorzugt 0.05 bis 5 ns, bevorzugt 0.1 bis 1 ns.

In einer weiteren bevorzugten Ausführungsform beträgt die in Schritt b) eingestellte Pulslänge höchstens 500 ns, bevorzugt höchstens 250 ns, bevorzugt höchstens 100 ns, bevorzugt höchstens 50 ns, bevorzugt höchstens 25 ns, bevorzugt höchstens 10 ns, bevorzugt höchstens 5 ns, bevorzugt höchstens 2,5 ns, bevorzugt höchstens 1 ns.

In einer weiteren bevorzugten Ausführungsform der vorliegenden Erfindung beträgt die in Schritt b) eingestellte Pulslänge höchstens 500 ps, bevorzugt höchstens 250 ps, bevorzugt höchstens 100 ps, bevorzugt höchstens 50 ps, bevorzugt höchstens 25 ps, bevorzugt höchstens 10 ps, bevorzugt höchstens 5 ps, bevorzugt höchstens 2,5 ps, bevorzugt höchstens 1 ps. Bevorzugt beträgt die in Schritt b) eingestellte Pulslänge höchstens 500 fs, bevorzugt höchstens 250 fs, bevorzugt höchstens 100 fs, bevorzugt höchstens 50 fs, bevorzugt höchstens 25 fs, bevorzugt höchstens 10 fs, bevorzugt höchstens 5 fs.

In einer bevorzugten Ausführungsform umfassen die in Schritt b) eingestellten Eigenschaften des mindestens einen gepulsten fokussierten Laserstrahls die Pulsenergie.

In einer bevorzugten Ausführungsform der vorliegenden Erfindung beträgt die in Schritt b) eingestellte Pulsenergie 1 µJ bis 20 µJ, bevorzugt 1 µJ bis 15 µJ, bevorzugt 1 µJ bis 10 µJ, bevorzugt 1 µJ bis 5 µJ, bevorzugt 2 µJ bis 10 µJ, bevorzugt 2 µJ bis 5 µJ, bevorzugt 3 µJ bis 10 µJ, bevorzugt 3 µJ bis 5 µJ, bevorzugt 5 µJ bis 10 µJ, bevorzugt 6 µJ bis 10 µJ, bevorzugt 8 µJ bis 10 µJ.

Gemäß einer bevorzugten Ausführungsform der vorliegenden Erfindung umfassen die in Schritt b) eingestellten Eigenschaften des mindestens einen gepulsten fokussierten Laserstrahls die Fokuslage.

Bevorzugt liegt der in Schritt b) eingestellte Fokus des gepulsten fokussierten Laserstrahls im Trägermaterial in einem Abstand von mindestens 0,1 µm, bevorzugt mindestens 0,25 µm, bevorzugt mindestens 0,5 µm, bevorzugt mindestens 1 µm, bevorzugt mindestens 2 µm, bevorzugt mindestens 3 µm, bevorzugt mindestens 4 µm, bevorzugt mindestens 5 µm, bevorzugt mindestens 10 µm, bevorzugt mindestens 15 µm, bevorzugt mindestens 20 µm, bevorzugt mindestens 25 µm, bevorzugt mindestens 30 µm, bevorzugt mindestens 35 µm, bevorzugt mindestens 40 µm, bevorzugt mindestens 45 µm, bevorzugt mindestens 50 µm, entfernt von der Grenzfläche zwischen Trägersubstrat und Trägermaterial des Transferträgers.

In einer bevorzugten Ausführungsform umfassen die in Schritt b) eingestellten Eigenschaften des mindestens einen gepulsten fokussierten Laserstrahls den Durchmesser des Brennflecks, insbesondere den Durchmesser des Laserstrahlprofils.

In einer bevorzugten Ausführungsform beträgt der Durchmesser des Laserbrennflecks, insbesondere der Durchmesser des Laserstrahlprofils, 10 µm bis 400 µm, bevorzugt 10 µm bis 300 µm, bevorzugt 10 µm bis 250 µm, bevorzugt 10 µm bis 200 µm, bevorzugt 15 µm bis 150 µm, bevorzugt 20 µm bis 100 µm, bevorzugt 25 µm bis 90 µm, bevorzugt 30 µm bis 80 µm, bevorzugt 40 µm bis 80 µm, bevorzugt 50 µm bis 70 µm.

In einer bevorzugten Ausführungsform erfolgt in Schritt c) die Abgabe mindestens eines gepulsten fokussierten Laserstrahls in der Form mindestens eines Ultrakurzpulses.

Gemäß einer bevorzugten Ausführungsform der vorliegenden Erfindung weist der in Schritt c) abgegebene mindestens eine gepulste fokussierte Laserstrahl ein ovales Strahlprofil auf. Besonders bevorzugt weist der in Schritt c) abgegebene mindestens eine gepulste fokussierte Laserstrahl ein kreisrundes Strahlprofil auf.

In einer weiteren bevorzugten Ausführungsform weist der in Schritt c) abgegebene mindestens eine gepulste fokussierte Laserstrahl ein ringförmiges Strahlprofil auf. Durch die Verwendung eines gepulsten fokussierten Laserstrahls mit einem ringförmigen Strahlprofil kann im Transfermaterial eine toroide Dampfblase erzeugt werden.

In einer weiteren bevorzugten Ausführungsform der vorliegenden Erfindung erfolgt in Schritt c) die Abgabe von mindestens zwei, bevorzugt mindestens drei, bevorzugt mindestens vier, gepulsten fokussierten Laserstrahlen. Bevorzugt erfolgt die Abgabe von mindestens zwei, bevorzugt mindestens drei, bevorzugt mindestens vier, gepulsten fokussierten Laserstrahlen zeitgleich.

In einer bevorzugten Ausführungsform erfolgt die Abgabe von mindestens zwei, bevorzugt mindestens drei, bevorzugt mindestens vier, gepulsten fokussierten Laserstrahlen zeitlich versetzt, insbesondere in einem Abstand von 5 ns bis 100 µs, bevorzugt 10 ns bis 50 µs, bevorzugt 10 ns bis 10 µs.

Besonders bevorzugt erfolgt die Abgabe von mindestens zwei, bevorzugt mindestens drei, bevorzugt mindestens vier, gepulsten fokussierten Laserstrahlen zeitlich versetzt in einem Abstand von mindestens 5 ns, bevorzugt mindestens 10 ns, bevorzugt mindestens 20 ns, bevorzugt mindestens 30 ns, bevorzugt mindestens 40 ns, bevorzugt mindestens 50 ns, bevorzugt mindestens 100 ns, bevorzugt mindestens 1 µs, bevorzugt mindestens 2 µs, bevorzugt mindestens 3 µs, bevorzugt mindestens 4 µs, bevorzugt mindestens 5 µs, bevorzugt mindestens 10 µs, bevorzugt mindestens 25 µs, bevorzugt mindestens 50 µs.

Durch den Einsatz einer Multispot-Optik und/oder diffraktive Strahlteiler kann auf diese Weise an unterschiedlichen Stellen zeitgleich oder zeitlich versetzt eine Übertragung des zu übertragenden Materials vom Transferträger auf einen Empfängerträger erfolgen. Dabei kann die Anordnung der einzelnen gepulsten fokussierten Laserstrahlen fest vorgegeben sein oder durch einen räumlichen Modulator (spatial light modulator, SLM) flexibel eingestellt werden.

In einer besonders bevorzugten Ausführungsform der vorliegenden Erfindung liegt das Zentrum der in Schritt c) ausgebildeten Dampfblase im Trägermaterial in einem Abstand von mindestens 0,1 µm, bevorzugt mindestens 0,25 µm, bevorzugt mindestens 0,5 µm, bevorzugt mindestens 1 µm, bevorzugt mindestens 2 µm, bevorzugt mindestens 3 µm, bevorzugt mindestens 4 µm, bevorzugt mindestens 5 µm, bevorzugt mindestens 10 µm, bevorzugt mindestens 15 µm, bevorzugt mindestens 20 µm, bevorzugt mindestens 25 µm, bevorzugt mindestens 30 µm, bevorzugt mindestens 35 µm, bevorzugt mindestens 40 µm, bevorzugt mindestens 45 µm, bevorzugt mindestens 50 µm, entfernt von der Grenzfläche zwischen Trägersubstrat und Trägermaterial des Transferträgers.

Besonders bevorzugt handelt es sich bei der im Schritt c) im Trägermaterial ausgebildeten Dampfblase um eine Dampfblase mit vorbestimmter Lokalisierung, Dimensionierung und Geometrie. So ist es durch mit Hilfe des erfindungsgemäßen Verfahrens möglich, durch eine geeignete Wahl der Eigenschaften des von der gepulsten, durchstimmbaren Laserstrahlquelle emittierten Laserstrahls, insbesondere durch eine geeignete Wahl der Laserwellenlänge, Rayleighlänge, Pulslänge, Pulsenergie, Fokuslage und/oder des Laserstrahlprofils, im Trägermaterial des Transferträgers gezielt eine Dampfblase auszubilden, die eine vorbestimmte Lokalisierung, Dimensionierung und Geometrie aufweist. Dadurch kann vorteilhafterweise die Jetbildung, insbesondere das Jetvolumen, die Jetlänge, die Jetgeschwindigkeit und/oder Jetform, und damit verbunden die Menge und Geschwindigkeit des vom Transferträger auf den Empfängerträger zu übertragenden Materials gezielt gesteuert werden.

Gemäß einer bevorzugten Ausführungsform der vorliegenden Erfindung beträgt die Distanz zwischen dem Transferträger und dem Empfängerträger in Schritt d) 20 µm bis 6000 µm, bevorzugt 20 µm bis 5000 µm, bevorzugt 20 µm bis 4000 µm, bevorzugt 20 µm bis 3000 µm, bevorzugt 20 µm bis 2000 µm, bevorzugt, 25 µm bis 1800 µm, bevorzugt 30 µm bis 1600 µm, bevorzugt 40 µm bis 1400 µm, bevorzugt 50 µm bis 1200 µm, bevorzugt 60 µm bis 1100 µm, bevorzugt 70 µm bis 1100 µm, bevorzugt 80 µm bis 1000 µm, bevorzugt 90 µm bis 1000 µm, bevorzugt 100 µm bis 1000 µm, bevorzugt 200 µm bis 900 µm, bevorzugt 300 µm bis 800 µm, bevorzugt 400 µm bis 800 µm.

Bevorzugt beträgt die Distanz zwischen dem Transferträger und dem Empfängerträger in Schritt d) mindestens 20 µm, bevorzugt mindestens 25 µm, bevorzugt mindestens 50 µm, bevorzugt mindestens 100 µm, bevorzugt mindestens 200 µm, bevorzugt mindestens 250 µm, bevorzugt mindestens 500 µm, bevorzugt mindestens 750 µm, bevorzugt mindestens 1000 µm, bevorzugt mindestens 1500 µm, bevorzugt mindestens 2000 µm, bevorzugt mindestens 3000 µm, bevorzugt mindestens 4000 µm, bevorzugt mindestens 5000 µm.

In einer weiteren bevorzugten Ausführungsform der vorliegenden Erfindung beträgt die Distanz zwischen dem Transferträger und dem Empfängerträger in Schritt d) höchstens 6000 µm, bevorzugt höchstens 5000 µm, bevorzugt höchstens 4000 µm, bevorzugt höchstens 3000 µm, bevorzugt höchstens 2500 µm, bevorzugt höchstens 2000 µm, bevorzugt höchstens 1750 µm, bevorzugt höchstens 1500 µm, bevorzugt höchstens 1250 µm, bevorzugt höchstens 1000 µm, bevorzugt höchstens 750 µm, bevorzugt höchstens 500 µm, bevorzugt höchstens 250 µm, bevorzugt höchstens 100 µm.

Gegenstand der vorliegenden Erfindung ist ferner eine Vorrichtung zur Laser-induzierten Übertragung von Material, umfassend:
- ein optisches System umfassend eine gepulste, durchstimmbare Laserstrahlquelle und
- eine Halterung zur Aufnahme eines Transferträgers.
wobei in der Vorrichtung die Laserwellenlänge, Rayleighlänge, Pulslänge, Pulsenergie, Fokuslage und/oder das Laserstrahlprofil mindestens eines von der Laserstrahlquelle emittierten gepulsten fokussierten Laserstrahls eingestellt werden können.

In besonders bevorzugten Ausführungsform der vorliegenden Erfindung handelt es sich bei der Vorrichtung zur Laser-induzierten Übertragung von Material um eine Vorrichtung zur Durchführung des erfindungsgemäßen Verfahrens.

Die vorliegende Erfindung betrifft auch die Verwendung eines gepulsten fokussierten Laserstrahls mit eingestellter Laserwellenlänge, Rayleighlänge, Pulslänge, Pulsenergie, Fokuslage und Laserstrahlprofil in einem LIFT-Verfahren zur Ausbildung mindestens einer Dampfblase mit definierter Lokalisierung, Dimensionierung und Geometrie in einem Trägermaterial eines Transferträgers.

Die im Zusammenhang mit dem erfindungsgemäßen Verfahren zum Laser-induzierten Übertragung von Material getroffenen Aussagen und beschriebenen Ausführungsformen gelten *mutatis mutandis* auch für die erfindungsgemäße Vorrichtung zur Laser-induzierten Übertragung von Material und die Verwendung eines gepulsten fokussierten Laserstrahls mit eingestellter Laserwellenlänge, Rayleighlänge, Pulslänge, Pulsenergie, Fokuslage und Laserstrahlprofil in einem LIFT-Verfahren zur Ausbildung mindestens einer Dampfblase mit definierter Lokalisierung, Dimensionierung und Geometrie in einem Trägermaterial eines Transferträgers.

Im Zusammenhang mit der vorliegenden Erfindung wird unter den Begriffen "umfassend" und "aufweisend" verstanden, dass zusätzlich zu den von diesen Begriffen explizit erfassten Elementen noch weitere, nicht explizit genannte Elemente hinzutreten können. Im Zusammenhang mit der vorliegenden Erfindung wird unter diesen Begriffen auch verstanden, dass allein die explizit genannten Elemente erfasst werden und keine weiteren Elemente vorliegen. In dieser besonderen Ausführungsform ist die Bedeutung der Begriffe "umfassend" und "aufweisend" gleichbedeutend mit dem Begriff "bestehend aus". Darüber hinaus erfassen die Begriffe "umfassend" und "aufweisend" auch Zusammensetzungen, die neben den explizit genannten Elementen auch weitere nicht genannte Elemente enthalten, die jedoch von funktionell und qualitativ untergeordneter Natur sind. In dieser Ausführungsform sind die Begriffe "umfassend" und "aufweisend" gleichbedeutend mit dem Begriff "im Wesentlichen bestehend aus".

Sofern im Zusammenhang mit der vorliegenden Erfindung die erste und zweite Nachkommastelle oder die zweite Nachkommastelle nicht angegeben sind/ist, sind/ist diese als 0 zu setzen.

Unter dem Begriff "und/oder" wird in Zusammenhang mit der vorliegenden Erfindung verstanden, dass alle Mitglieder einer Gruppe, welche durch den Begriff "und/oder" verbunden sind, sowohl alternativ zueinander als auch jeweils untereinander kumulativ in einer beliebigen Kombination offenbart sind. Dies bedeutet für den Ausdruck "A, B und/oder C", dass folgender Offenbarungsgehalt darunter zu verstehen ist: a) A oder B oder C oder b) (A und B) oder c) (A und C) oder d) (B und C) oder e) (A und B und C).

Weitere Ausführungsformen der vorliegenden Erfindung ergeben sich aus den Unteransprüchen.

Die vorliegende Erfindung wird im Folgenden anhand von Beispielen illustriert.

### Beispiel 1:

### Einfluss der Wellenlänge auf biologisches Material

Durch Abstimmung der Wellenlänge auf den Absorptionspeak von Wasser bei 2940 nm kann vorteilhafterweise auf einen Absorber wie er im AFA-LIFT oder BA-LIFT benötigt wird verzichtet werden.

Es konnte gezeigt werden, dass mit dem erfindungsgemäßen Verfahren zuverlässig biologisches Material von einem Transferträger auf einen Empfängerträger übertragen werden kann und dass auf diese Weise übertragene Säugetierzellen beim Transfer eine signifikant höhere Überlebensrate aufweisen als bei AFA-LIFT mit 355 nm Wellenlänge und Titan-Absorberschicht.

### Beispiel 2:

### Übertragung mittels spezifisches Gasblasengeometrie

Es konnte gezeigt werden, dass durch die Verwendung eines gepulsten fokussierten Laserstrahls mit ringförmigem Strahlprofil im Trägermaterial toroide Dampfblasen erzeugt werden, mit deren Hilfe eine erfolgreiche Übertragung von Zellen von einem Transferträger auf einen Empfängerträger erfolgt ist.

## Patentansprüche

1. Verfahren zur Laser-induzierten Übertragung von Material umfassend die Schritte:
a) Bereitstellung eines Transferträgers umfassend ein für Laserstrahlung durchlässiges Trägersubstrat und ein das zu übertragende Material umfassendes Trägermaterial sowie einer gepulsten, durchstimmbaren Laserstrahlquelle,
b) Einstellung der Eigenschaften mindestens eines gepulsten fokussierten Laserstrahls,
c) Emittierung des mindestens einen gepulsten fokussierten Laserstrahls durch das Trägersubstrat in das Trägermaterial, wobei der mindestens eine gepulste fokussierte Laserstrahl die in Schritt b) eingestellten Eigenschaften aufweist und in dem Trägermaterial zur Ausbildung mindestens einer Dampfblase führt, und
d) Übertragung des zu übertragenden Materials vom Transferträger auf einen Empfängerträger.

2. Verfahren nach Anspruch 1, **dadurch gekennzeichnet, dass** der Transferträger keine Absorberschicht aufweist.

3. Verfahren nach einem der vorhergehenden Ansprüche, **dadurch gekennzeichnet, dass** das Trägermaterial des Transferträgers eine Schichtdicke von 1 bis 500 µm aufweist.

4. Verfahren nach einem der vorhergehenden Ansprüche, **dadurch gekennzeichnet, dass** das Trägermaterial eine Flüssigkeit oder ein wasserhaltiges Gel ist.

5. Verfahren nach Anspruch 4, **dadurch gekennzeichnet, dass** das wasserhaltige Gel mindestens eine Substanz ausgewählt aus der Gruppe bestehend aus Gelatine, Agarose, Chitosan, Matrigel, Kollagen und Methylzellulose, umfasst.

6. Verfahren nach einem der vorhergehenden Ansprüche, **dadurch gekennzeichnet, dass** die in Schritt b) eingestellten Eigenschaften des mindestens einen gepulsten fokussierten Laserstrahls ausgewählt sind aus der Gruppe bestehend aus Laserwellenlänge, Rayleighlänge, Pulslänge, Pulsenergie, Fokuslage und Laserstrahlprofil.

7. Verfahren nach einem der vorhergehenden Ansprüche, **dadurch gekennzeichnet, dass** die in Schritt b) eingestellten Eigenschaften des mindestens einen gepulsten fokussierten Laserstrahls eine Wellenlänge im Bereich von 2,5 bis 3,5 µm, bevorzugt 2,75 bis 3,25 µm, umfassen.

8. Verfahren nach einem der vorhergehenden Ansprüche, **dadurch gekennzeichnet, dass** die in Schritt b) eingestellten Eigenschaften des mindestens einen gepulsten fokussierten Laserstrahls eine Pulslänge im Bereich von 1 fs bis 500 ns umfassen.

9. Verfahren nach einem der vorhergehenden Ansprüche, **dadurch gekennzeichnet, dass** die in Schritt b) eingestellten Eigenschaften des mindestens einen gepulsten fokussierten Laserstrahls eine Pulsenergie im Bereich von 1 µJ bis 20 µJ umfassen.

10. Verfahren nach einem der vorhergehenden Ansprüche, **dadurch gekennzeichnet, dass** die in Schritt b) eingestellten Eigenschaften des mindestens einen gepulsten fokussierten Laserstrahls eine Fokuslage des Laserstrahls im Trägermaterial in einem Abstand von mindestens 0,1 µm entfernt von der Grenzfläche zwischen Trägersubstrat und Trägermaterial des Transferträgers umfassen.

11. Verfahren nach einem der vorhergehenden Ansprüche, **dadurch gekennzeichnet, dass** die in Schritt b) eingestellten Eigenschaften des mindestens einen gepulsten fokussierten Laserstrahls einen Durchmesser des Laserbrennflecks, insbesondere einen Durchmesser des Laserstrahlprofils, im Bereich von 10 µm bis 400 µm umfassen.

12. Verfahren nach einem der vorhergehenden Ansprüche, **dadurch gekennzeichnet, dass** das Zentrum der in Schritt c) ausgebildeten Dampfblase im Trägermaterial in einem Abstand von mindestens 0,1 µm entfernt von der Grenzfläche zwischen Trägersubstrat und Trägermaterial des Transferträgers liegt.

13. Verfahren nach einem der vorhergehenden Ansprüche, **dadurch gekennzeichnet, dass** der in Schritt c) abgegebene mindestens eine gepulste fokussierte Laserstrahl ein ringförmiges Strahlprofil aufweist.

14. Vorrichtung zur Laser-induzierten Übertragung von Material, umfassend:
- ein optisches System umfassend eine gepulste, durchstimmbare Laserstrahlquelle und
- eine Halterung zur Aufnahme eines Transferträgers.
wobei in der Vorrichtung die Laserwellenlänge, Rayleighlänge, Pulslänge, Pulsenergie, Fokuslage und das Laserstrahlprofil mindestens eines von der Laserstrahlquelle emittierten gepulsten fokussierten Laserstrahls eingestellt werden können.

15. Verwendung eines gepulsten fokussierten Laserstrahls mit eingestellter Laserwellenlänge, Rayleighlänge, Pulslänge, Pulsenergie, Fokuslage und Laserstrahlprofil in einem LIFT-Verfahren zur Ausbildung mindestens einer Dampfblase mit definierter Lokalisierung, Dimensionierung und Geometrie in einem Trägermaterial eines Transferträgers.
